# EUROPÄISCHE PATENTSCHRIFT

(11) **EP 3 312 873 B1**
(45) Veröffentlichungstag und Bekanntmachung des Hinweises auf die Patenterteilung: **24.02.2021**
(21) Anmeldenummer: 17401111.4
(22) Anmeldetag: 17.10.2017
(51) Int. Cl.: H01L 21/673, H01L 21/677

(54) **ARBEITSEINHEIT ZUR UMSETZUNG VON SUBSTRATEN**
DEVICE FOR TRANSFERRING SUBSTRATES
UNITÉ DE TRAVAIL POUR LE TRANSFERT DE SUBSTRATS

(30) Priorität: 19.10.2016 DE 102016119888
(43) Veröffentlichungstag der Anmeldung: 25.04.2018
(73) Patentinhaber: ASYS Automatic Systems GmbH & Co. KG, 73614 Schorndorf (DE)
(72) Erfinder: HÜGLER, Klaus, 73630 Remshalden (DE)
(74) Vertreter: Müller, Gottfried

(56) Entgegenhaltungen:
- DE-A1-102004 058 108
- US-A- 5 431 600
- US-A- 5 664 925
- US-A- 5 752 796
- US-A- 6 062 808
- US-A- 6 120 229
- US-A1- 2002 099 470
- US-A1- 2015 083 640

## Beschreibung

Die Erfindung betrifft eine Arbeitseinheit zur Umsetzung von Substraten gemäß Anspruch 1.

Arbeitseinheiten zur Umsetzung von Substraten mit wenigstens einem Transportbehälter und wenigstens einer Substrataufnahme, wobei Transportbehälter und Substrataufnahme im Zugriffsbereich einer in einer Übergabestation aufgenommenen Handhabungseinheit zur Umsetzung der Substrate angeordnet sind, sind unter unterschiedlichen Arbeitsbedingungen insbesondere auch in Reinraumanlagen vielfältig im Einsatz.

Eine in einer solchen Arbeitseinheit einsetzbare Handhabungseinheit ist aus der US 2004/0013503 A1 bekannt. Diese Handhabungseinheit weist eine gelenkig an einem Endarm angesetzte Hand auf, welche, quasi als übereinanderliegende Finger, mit einer Kaskade beabstandet übereinanderliegender, schaufelartig flächiger Tragauflagen für die Substrate versehen ist. Über die Tragauflagen werden die Substrate auf Substrataufnahmen umgesetzt, welche - entsprechend den Tragauflagen - abgelegte Substrate randseitig untergreifende Absetzauflagen aufweisen. Seitens der Handhabungseinheit und der Substrataufnahmen sind also jeweils Auflagen für die Substrate vorzusehen und die Substrate müssen entsprechend auch zwischen diesen Auflagen jeweils umgesetzt werden.

Bekannt ist es ferner aus der US 5,752,796 A - entsprechend auch der US 5,664,925 A sowie der DE 10 2004 058 108 A1 - Arbeitseinheiten zur Umsetzung von Substraten, umfassend wenigstens einen Transportbehälter mit entnehmbarem Trageinsatz mit Tragauflagen für die Substrate und wenigstens einer Substrataufnahme, die im Zugriffsbereich einer in einer Übergabestation aufgenommenen Handhabungseinheit zur Umsetzung der Substrate angeordnet ist, so zu gestalten, dass der Trageinsatz gegen die auf den Transportbehälter auszufahrende Handhabungseinheit lagefest verkoppelt mit der Handhabungseinheit einen Bestandteil deren Endeffektors bildet.

Die Unterbringung des Trageinsatzes im Transportbehälter bedingt eine entsprechend große Durchtrittsöffnung für den Trageinsatz in der Wandung des Transportbehälters, die ein Deckelteil entsprechender Größe bedingt.

Es besteht das Bedürfnis, solche Arbeitseinheiten möglichst kostengünstig bereitzustellen, wobei auch deren hinsichtlich ihrer Funktionen geforderte Variabilität mit möglichst wenig Bauteilen und Bauelementen zu verwirklichen sein soll, um für anderweitige Einsatzfälle zumindest in ähnlicher Ausgestaltung bereits nutzbar zu sein.

Im Hinblick darauf bildet bei der erfindungsgemäßen Gestaltung der Arbeitseinheit das Deckelteil einen Bestandteil des Endeffektors der Handhabungseinheit und trägt dadurch zur steifen Ausbildung des Trageinsatzes auch bei nur randseitigen Tragauflagen für die Substrate bei, wobei das Deckelteil gleichzeitig eine steife Verbindung zur Handhabungseinheit ermöglicht und damit die Nutzung des Trageinsatzes als Endeffektor zur Handhabungseinheit begünstigt.

Zweckmäßigerweise ist die Verbindung zwischen Deckelteil und Handhabungseinheit so gestaltet, dass in wechselseitiger Aussteifung die Handhabungseinheit in einem dem Deckelteil entsprechenden Koppelglied ausläuft, was zur Reduzierung der Belastung des Deckelteils führt, so dass dieses im kritischen Belastungsfall des über die Handhabungsvorrichtung getragenen, beladenen Trageinsatzes zusätzlich ausgesteift wird. Die entsprechende Verbindung des Deckelteils zum Handhabungsteil lässt sich nicht nur mechanisch, sondern vorteilhafterweise auch als Unterdruckverbindung ausgestalten, so dass zusätzlich Belastungen des Arbeitsraumes durch Verunreinigungen des Deckelteiles vermieden werden.

Durch die so erreichte Zusammenfassung der Handhabungseinheit mit dem Trageinsatz des Transportbehälters wird aber nicht nur ein vereinfachter Gesamtaufbau erreicht, und zwar durch Wegfall eines gesondert zum Trageinsatz vorgesehenen Endeffektors, sondern es wird auch die Umsetzung der Substrate bei der Entnahme der Substrate aus dem Transportbehälter auf den Endeffektor vermieden, so dass ein zusätzlicher Umsetzvorgang für die Substrate entfällt, der insbesondere unter Reinraumbedingungen, aber auch als zusätzliche Belastung für die Substrate kritisch ist.

Für einen Reinraumgegebenheiten berücksichtigenden Einsatz der Arbeitseinheit erweist es sich als zweckmäßig, wenn der Transportbehälter mit in diesem aufgenommenen Trageinsatz als atmosphärisch geschlossene Einheit ausgebildet wird, insbesondere mit seitens eines Tragpodestes zur Übergabeeinheit vorgesehenen Versorgungsanschlüssen für auf dem Tragpodest abgesetzte Transportbehälter. Steht der Transportbehälter unter Unterdruck, so lässt sich die entsprechende Druckdifferenz auch zur Sicherung des den Transportbehälter verschließenden Deckelteils, gegebenenfalls ergänzend zu sonstigen Sicherungsmaßnahmen, nutzen.

Eine den Transportbehältern entsprechende Konditionierung der Atmosphäre im Arbeitsraum der Übergabestation wie auch im Übergang auf zur Übergabestation vorgesehene Substrataufnahmen lässt sich in einfacher Weise dadurch erreichen, dass die Arbeitseinheit atmosphärisch gegeneinander abgrenzende Aufbauteile insbesondere zwischen der Übergabestation mit in dieser aufgenommener Handhabungseinheit sowie zur Übergabestation mit umfangsseitigen Transportbehältern oder Substrataufnahmen aufweist. Dadurch lassen sich entsprechend dem Bedarf in der Arbeitseinheit unterschiedliche Arbeitsatmosphären einstellen, und zwar in einfacher Weise dadurch, dass zwischen der Übergabestation und den umfangsseitig liegenden Transportbehältern und/oder Substrataufnahmen schachtartige Spülkanäle mit Durchtrittsöffnungen für die Handhabungseinheit vorgesehen werden, die über schleusenartige, den schachtartigen Spülkanälen zugeordnete Absperrungen verschließbar sind.

Die Erfindung wird mit weiteren Merkmalen prinzipiell anhand der nachfolgenden Zeichnungen erläutert, die jeweils eine Arbeitseinheit mit Übergabestation und umfangsseitig angedocktem Transportbehälter und Substrataufnahme zeigen, wobei
- Fig. 1: die in der Übergangsstation angeordnete Handhabungseinheit in einer Neutrallage zeigt, in der die Handhabungseinheit keinen Zugriff auf Transportbehälter und/oder Substrataufnahme hat,
- Fig. 2: die in der Übergabestation vorgesehene Handhabungseinheit im Zugriff auf einen Trageinsatz im Transportbehälter, bei atmosphärisch geschlossenem Übergang von der Übergabestation auf die Substrataufnahme,
- Fig. 3: eine Arbeitssituation mit Zugriff des als Endeffektor genutzten Trageinsatzes auf die Substrataufnahme,
- Fig. 4: die Übergabestation als Verbindungsglied zwischen zwei Transportbehältern bei unterschiedlichen atmosphärischen Bedingungen in den Transportbehältern, und

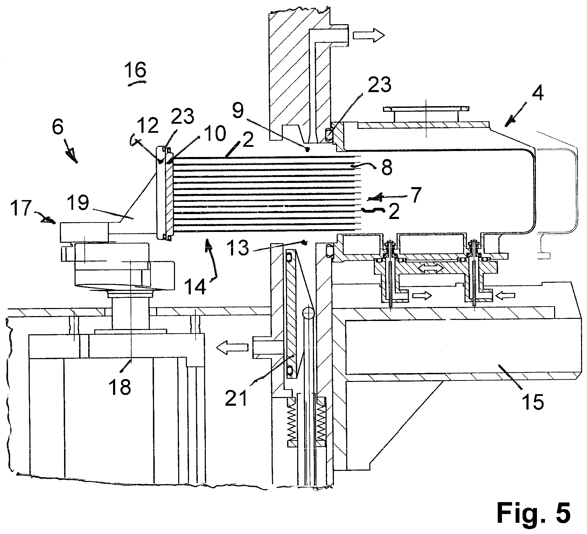

- Fig. 5: eine vergrößerte Ausschnittsdarstellung zur Veranschaulichung der Verbindung der Handhabungseinheit zum Deckelteil des Trageinsatzes.

In den gezeigten Ausführungsformen der erfindungsgemäßen Arbeitseinheit 1 zur Umsetzung von Substraten 2 wird die Arbeitseinheit 1 jeweils in einer für Reinraumanlagen geeigneten Ausführungsform erläutert. Im Rahmen der Erfindung liegt es aber auch, die Arbeitseinheit 1 - bei prinzipiell gleichem Aufbau, vereinfacht - für die Umsetzung von Substraten oder dergleichen unter sonstigen atmosphärischen Bedingungen einzusetzen.

Dargestellt ist die Arbeitseinheit 1 jeweils in einem grundsätzlichen Aufbau mit einer Übergabestation 3 und peripher zur Übergabestation 3 liegenden Substratträgern, veranschaulicht vorliegend durch einen Transportbehälter 4 und eine Substrataufnahme 5. Als Transportbehälter 4 ist eine vakuumtaugliche Transportbox veranschaulicht, die umfangsseitig überdeckend zu einer Durchtrittsöffnung 9 der Übergabestation 3 auf einem zur Übergabestation 3 lagefesten Tragpodest 15 aufsitzt. Zum Tragpodest 15 ist der Transportbehälter 4 insbesondere in Richtung auf den Umfang der Übergabestation 3 verschiebbar aufgesetzt, wobei zum Aufbau und/oder Erhalt atmosphärischer Sonderbedingungen im Transportbehälter 4 über das Tragpodest 15 laufende Versorgungsanschlüsse veranschaulicht sind.

Entsprechend der Nutzung des Transportbehälters 4 unter Erhalt atmosphärischer Sonderbedingungen gegenüber der Umgebung der Arbeitseinheit 1 ist der Transportbehälter 4 im Überdeckungsbereich zur Durchtrittsöffnung 9 über ein Deckelteil 10 verschließbar, das Bestandteil eines Trageinsatzes 7 zum Transportbehälter 4 ist. Der Trageinsatz 7 mit Deckelteil 10 und vom Deckelteil 10 getragenen Tragauflagen 8 für Substrate 2 ist über eine Handhabungseinheit 6 umzusetzen, die in der Übergabestation 3 liegt und, bezogen auf den Transportbehälter 4, über die Durchtrittsöffnung 9 auf das Deckelteil 10 zugreifen kann.

Die Handhabungseinheit 6 ist schematisch als Roboter mit mehrgliedrigem Arm veranschaulicht, beispielsweise als Scararoboter, dessen Endarm 17 auf den Transportbehälter 4 zugreift.

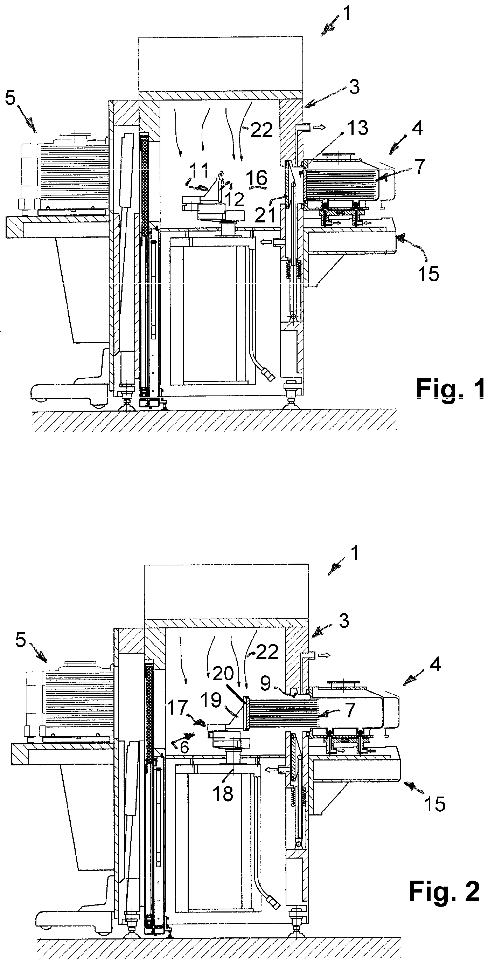

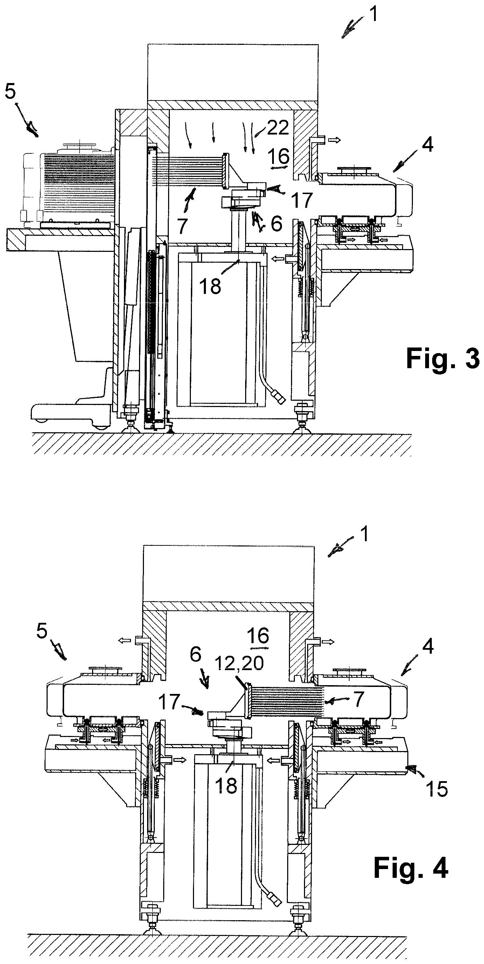

Der Endarm 17 ist gegen sein freies Ende auslaufend, und in der Funktion eines Endeffektors 14, durch den Trageinsatz 7 gebildet, der über sein Deckelteil 10 mit dem Anschlussteil 19 der Handhabungseinheit 6 verbunden ist. Das Anschlussteil 19 ist zum Trageinsatz 7 über das Deckelteil 10 verkoppelt, dem seitens des Anschlussteils 19 im Ausführungsbeispiel als Greiferteil 12 ein plattenförmiges Koppelglied 20 entspricht. Die Verbindung zwischen Deckelteil 10 und Koppelglied 20 kann in bekannter Weise lagefest mechanisch oder auch anderweitig, beispielsweise mittels Unterdruck oder auch magnetisch selbsttätig erfolgen. Ist der Trageinsatz 7 entsprechend verkoppelt zur Handhabungseinheit 6 Bestandteil des Endeffektors 14 der Handhabungseinheit 6 geworden, so ist, wie Fig. 1 bis 4 veranschaulichen, die Umsetzung von Substraten 2 zwischen dem Transportbehälter 4 und sonstigen Substrataufnahmen, beispielsweise einer Substrataufnahme 5 in Form einer sogenannten FOUP, ohne dazwischen liegende Umsetzschritte möglich.

Im Hinblick auf die jeweiligen Arbeitsgegebenheiten der Arbeitseinheit 1, so insbesondere bei für diese geforderten Reinraumbedingungen, kann diese vorgelagert zu den jeweiligen Durchtrittsöffnungen 9 schachtartige Spülkanäle 13 (Spülkanalschächte) aufweisen, in denen im Durchgriffsweg der Handhabungseinheit 6 auf Transportbehälter 4 Sperrabdeckungen 21 liegen, über die zum jeweiligen geschlossenen Deckelteil 10 gegen den Arbeitsraum 16 Spülräume abgegrenzt sind, so dass etwaige am jeweiligen Deckelteil 10 anhaftende Verunreinigungen die Arbeitsräume nicht belasten. In entsprechender Weise kann der Arbeitsraum 16 insgesamt auch zusätzlich gespült werden, wie durch die Pfeile 22 in Fig. 1 bis 3 veranschaulicht, und auch an sich bekannt.

Im Hinblick auf eine jeweilige atmosphärische Abgrenzung sowohl zwischen geschlossenem Deckelteil 10 und Gehäuse des Transportbehälters 4 wie auch zwischen Anschlussteil 19 zum Deckelteil 10, aber auch bei sonstigen Dichtgrenzen, sind in der Erfindung teilweise entsprechende Dichtungsanordnungen 23 beispielhaft veranschaulicht, so unter anderem auch in der Dichtgrenze zwischen an die Wandung der Übergabestation 3 anliegenden Gehäuse des Transportbehälters 4.

Insgesamt gesehen ist somit durch die Erfindung eine Arbeitseinheit 1 geschaffen, bei der - über einen entnehmbaren Trageinsatz 7 mit Tragauflagen 8 für Substrate 2 eines Transportbehälters 4 durch Verkopplung des Trageinsatzes 7 mit einer Handhabungseinheit 6 - durch den Trageinsatz 7 ein Bestandteil des Endeffektors 14 der Handhabungseinheit 6 gebildet werden kann, so dass sich ein sehr einfacher Aufbau ergibt. Ist der Transportbehälter 4 mit einem gasdicht schließenden, an seiner Vorderseite angebrachten Deckelteil 10 versehen, so kann der Transportbehälter 4 mit einer Sonderatmosphäre versehen werden, bevor, während oder nachdem die Substrate darin abgelegt werden. Diese Sonderatmosphäre kann bei deutlich geringerem Druck als in der Umgebung auch dazu dienen, das Deckelteil 10 zum Transportbehälter 4 über die Druckdifferenz angepresst zu halten, wobei es zweckmäßig ist, wenn die Handhabungseinheit 6 mit ihrem auf das Deckelteil 10 zugreifenden Greiferteil 12 als Koppelglied 20 die Außenseite des Deckelteils 10 weitgehend gasdicht abdeckt.

Verunreinigungen der Arbeitsatmosphäre durch etwa anhaftende Partikel, Flüssigkeiten und/oder Gase werden somit vermieden. Insbesondere hat die Erfindung den Vorteil, über die Gestaltung des Trageinsatzes 7, insbesondere dessen Tragauflagen 8 für die Substrate 2 auch den unmittelbaren Zugriff auf anderweitig gestaltete Substrataufnahmen 5 zu ermöglichen, so dass die erfindungsgemäße Arbeitseinheit mit Vorteil in gängige Transportsysteme integriert werden kann.

Es ist somit mit gängigen Mitteln eine Arbeitseinheit 1 zu gestalten, bei der automatisiert ein Trageinsatz 7 mit Tragauflagen 8 und Substraten 2 einem Transportbehälter 4 entnommen werden können und die Substrate 2 auf Substrataufnahmen, insbesondere auch geschlossenen Transportbehältern zugeordnete Substrataufnahmen zugeführt werden können. Bei umgekehrter Abfolge des Arbeitsablaufs kann über den Trageinsatz 7 mit Tragauflagen 8 und Substraten 2 der Trageinsatz 7 auch als Endeffektor 14 der Handhabungseinheit 6 genutzt werden, um Substrate 2 einem weiteren Behälter zu entnehmen und/oder in einer anderen Substrataufnahme oder einem anderen Transportbehälter zuzuführen.

All dies ist möglich, unter Aufrechterhaltung besonderer atmosphärischer Bedingungen hinsichtlich der Zusammensetzung, der Temperatur usw. in dem Arbeitsraum 16, in dem die Handhabungseinheit 6 den Trageinsatz 7 mit den Tragauflagen 8 und den Substraten 2 bewegt, ggf. ergänzt durch weitere Schutzmaßnahmen, wie beispielsweise Durchströmung des Arbeitsraumes 16 mit langsam nachströmender gereinigter Luft, Schutzgas oder dergleichen. Zusätzliche Maßnahmen gegen Verunreinigungen des Arbeitsraumes 16 sind dadurch möglich, dass der Arbeitsraum 16 bezogen auf die Position des Transportbehälters 4 so angeschlossen wird, dass ein Zwischenraum - schachtartiger Spülkanal 13 - zwischen Arbeitsraum 16 und geschlossenem Transportbehälter 4 zur Reinigung der Oberfläche des Behälters 4 gesondert gespült und/oder den atmosphärischen Bedingungen des Arbeitsraumes angepasst wird, wenn der Transportbehälter 4 an die Übergabestation 3 andockt.

Es ergeben sich also vielfältigste Einsatzmöglichkeiten, und zwar unter Berücksichtigung vielfältiger, auch bezogen auf Reinraumanlagen ungünstiger Randbedingungen.

Durch die Erfindung wird somit eine Lösung geschaffen, die sich dadurch auszeichnet, dass ein separater Trageinsatz 7 durch Zugriff einer Handhabungseinheit 6 und Verkopplung gegen diese zu einem Bestandteil eines mehrgliedrigen Armes seiner Handhabungseinheit 6 wird und den Endeffektor (14) dieser Handhabungseinheit 6 bildet.

Die Erfindung wird durch den angehängten Satz von Patentansprüchen definiert. Die Beschreibung und die Zeichnungen sind jedoch zur Auslegung der Patentansprüche heranzuziehen.

## Patentansprüche

1. Arbeitseinheit (1) zur Umsetzung von Substraten (2) mit wenigstens einem umfangsseitig über ein Deckelteil (10) zu verschließenden Transportbehälter (4) mit entnehmbarem Trageinsatz (7) mit Tragauflagen (8) für die Substrate (2) sowie mit wenigstens einer Substrataufnahme (5) und einer in einer Übergabestation (3) aufgenommenen Handhabungseinheit (6), wobei der Transportbehälter (4) und die Substrataufnahme (5) im Zugriffsbereich der Handhabungseinheit (6) zur Umsetzung der Substrate (2) angeordnet sind, wobei der wenigstens eine Transportbehälter (4) den Trageinsatz (7) aufnimmt und der Trageinsatz (7) derart ausgebildet ist, dass er gegen die auf den Transportbehälter (4) zufahrende Handhabungseinheit (6) lagefest über das Deckelteil (10) verkoppelt ist und durch die lagefeste Verkoppelung gegen die auf den Transportbehälter zufahrende Handhabungseinheit (6) einen Bestandteil eines Endeffektors (14) der Handhabungseinheit (6) bildet.

2. Arbeitseinheit nach Anspruch 1,
**dadurch gekennzeichnet,**
**dass** die Handhabungseinheit (6) in der Koppelverbindung (11) zum Trageinsatz (7) ein auf das Deckelteil (10) formlich abgestimmtes Greiferteil (12) aufweist.

3. Arbeitseinheit nach Anspruch 2,
**dadurch gekennzeichnet,**
**dass** die Koppelverbindung (11) zwischen Deckelteil (10) und Greiferteil (12) atmosphärisch abgeschirmt, insbesondere überspült ist.

4. Arbeitseinheit nach einem der vorhergehenden Ansprüche,
**dadurch gekennzeichnet,**
**dass** der Trageinsatz (7) als Traggerüst nach Art eines Kammgreifers ausgebildet ist.

5. Arbeitseinheit nach einem der vorhergehenden Ansprüche,
**dadurch gekennzeichnet,**
**dass** der Transportbehälter (4) mit in diesem aufgenommenen Trageinsatz (7) als atmosphärisch geschlossene Einheit ausgebildet ist.

6. Arbeitseinheit nach Anspruch 5,
**dadurch gekennzeichnet,**
**dass** die Arbeitseinheit (1) zum Transportbehälter (4) vorgesehene Versorgungsanschlüsse aufweist, die über ein zur Übergabestation (3) lagefestes Tragpodest (15) für den Transportbehälter (4) laufen.

7. Arbeitseinheit nach einem der vorhergehenden Ansprüche,
**dadurch gekennzeichnet,**
**dass** die Arbeitseinheit (1) atmosphärisch gegeneinander abgegrenzte Aufbauteile aufweist, die insbesondere durch die Übergabestation (3) mit darin aufgenommener Handhabungseinheit (6) sowie Transportbehälter (4) und/oder Substrataufnahmen (5) gebildet sind.

8. Arbeitseinheit nach Anspruch 7,
**dadurch gekennzeichnet,**
**dass** die Arbeitseinheit (1) im Übergang von der Übergabestation (3) und umfangsseitig zu dieser liegenden Transportbehältern (4) und/oder Substrataufnahmen (5) vorgelagert zu den jeweiligen Durchtrittsöffnungen (9) schachtartige Spülkanäle (13) aufweist, die über schleusenartige Sperrabdeckungen (21) verschließbar sind.

## Claims

1. Work unit (1) for transferring substrates (2) with at least one transport container (4) which is to be closed circumferentially by a cover part (10) and has a removable carrying insert (7) with carrying pads (8) for the substrates (2), and with at least one substrate receptacle (5) and a handling unit (6), which is accommodated in a transfer station (3), wherein the transport container (4) and the substrate receptacle (5) are arranged in the access region of the handling unit (6) for transferring the substrates (2), wherein the at least one transport container (4) receives the carrying insert (7), and the carrying insert (7) is configured in such a manner that it is coupled in a fixed position by the cover part (10) against the handling unit (6) heading for the transport container (4) and, by means of the positionally fixed coupling against the handling unit (6) heading for the transport container, forms part of an end effector (14) of the handling unit (6).

2. Work unit according to Claim 1,
**characterized**
**in that** the handling unit (6) in the coupling connection (11) to the carrying insert (7) has a gripper part (12) matched to the shape of the cover part (10).

3. Work unit according to Claim 2,
**characterized**
**in that** the coupling connection (11) between cover part (10) and gripper part (12) is atmospherically shielded, in particular flooded.

4. Work unit according to one of the preceding claims,
**characterized**
**in that** the carrying insert (7) is configured as a carrying frame in the manner of a comb-type gripper.

5. Work unit according to one of the preceding claims,
**characterized**
**in that** the transport container (4) with the carrying insert (7) accommodated therein is configured as an atmospherically sealed unit.

6. Work unit according to Claim 5,
**characterized**
**in that** the work unit (1) has supply connections which are provided for the transport container (4) and run via a carrying platform (15), which is positionally fixed with respect to the transfer station (3), for the transport container (4).

7. Work unit according to one of the preceding claims,
**characterized**
**in that** the work unit (1) has structural parts which are atmospherically delimited from one another and are formed in particular by the transfer station (3) with the handling unit (6) accommodated therein, and by the transport container (4) and/or substrate receptacles (5) .

8. Work unit according to Claim 7,
**characterized**
**in that** the work unit (1) in the transition from the transfer station (3) to transport containers (4) located circumferentially with respect thereto and/or to substrate receptacles (5) has shaft-like flushing channels (13) that are mounted upstream of the respective passage openings (9) and are closable via sluice-like shut-off coverings (21).

## Revendications

1. Unité de travail (1) pour le changement de place de substrats (2), munie d'au moins un contenant de transport (4) destiné à être fermé sur la circonférence par l'intermédiaire d'une partie couvercle (10), muni d'un insert de soutien amovible (7) muni de supports (8) pour les substrats (2), ainsi que munie d'au moins un logement de substrat (5) et d'une unité de manipulation (6) logée dans une station de transfert (3), le contenant de transport (4) et le logement de substrat (5) étant agencés dans la zone d'accès de l'unité de manipulation (6) pour le changement de place des substrats (2), ledit au moins un contenant de transport (4) logeant l'insert de soutien (7) et l'insert de soutien (7) étant configuré de telle sorte qu'il est couplé contre l'unité de manipulation (6) se déplaçant vers le contenant de transport (4) en position fixe par l'intermédiaire de la partie couvercle (10) et forme par le couplage en position fixe contre l'unité de manipulation (6) se déplaçant vers le contenant de transport un constituant d'un effecteur terminal (14) de l'unité de manipulation (6).

2. Unité de travail selon la revendication 1, **caractérisée en ce que** l'unité de manipulation (6) comprend dans la liaison de couplage (11) avec l'insert de soutien (7) une partie préhenseur (12) adaptée en forme à la partie couvercle (10).

3. Unité de travail selon la revendication 2, **caractérisée en ce que** la liaison de couplage (11) entre la partie couvercle (10) et la partie préhenseur (12) est protégée atmosphériquement, notamment balayée.

4. Unité de travail selon l'une quelconque des revendications précédentes, **caractérisée en ce que** l'insert de soutien (7) est configuré en tant que squelette de soutien à la façon d'un préhenseur en peigne.

5. Unité de travail selon l'une quelconque des revendications précédentes, **caractérisée en ce que** le contenant de transport (4) est configuré avec un insert de soutien (7) logé dans celui-ci sous la forme d'une unité fermée atmosphériquement.

6. Unité de travail selon la revendication 5, **caractérisée en ce que** l'unité de travail (1) comprend des raccordements d'alimentation prévus pour le contenant de transport (4), qui passent par une plateforme de soutien (15) en position fixe par rapport à la station de transfert (3), pour le contenant de transport (4).

7. Unité de travail selon l'une quelconque des revendications précédentes, **caractérisée en ce que** l'unité de travail (1) comprend des composants délimités atmosphériquement les uns des autres, qui sont notamment formés par la station de transfert (3) avec l'unité de manipulation (6) logée dans celle-ci, ainsi que le contenant de transport (4) et/ou les logements de substrat (5).

8. Unité de travail selon la revendication 7, **caractérisée en ce que** l'unité de travail (1) comprend des canaux de rinçage (13) en forme de puits dans la transition depuis la station de transfert (3) et les contenants de transport (4) situés en circonférence de celle-ci et/ou les logements de substrat (5) en amont des ouvertures de passage respectives (9), qui peuvent être fermés par des recouvrements de blocage (21) en forme de vanne.
